(19) **Europäisches Patentamt**

**European Patent Office**

**Office européen des brevets**

(11) Veröffentlichungsnummer: **0 258 214 B1**

(12) # EUROPÄISCHE PATENTSCHRIFT

(45) Veröffentlichungstag der Patentschrift:
20.03.91 Patentblatt 91/12

(51) Int. Cl.⁵: **G01R 31/00, B60Q 11/00**

(21) Anmeldenummer: **86900737.7**

(22) Anmeldetag: **15.01.86**

(86) Internationale Anmeldenummer:
**PCT/DE86/00012**

(87) Internationale Veröffentlichungsnummer:
**WO 86/05888 09.10.86 Gazette 86/22**

(54) **EINRICHTUNG ZUR KONTROLLE VON ELEKTRISCHEN VERBRAUCHERN IN KRAFTFAHRZEUGEN.**

(30) Priorität: **02.04.85 DE 3511967**

(43) Veröffentlichungstag der Anmeldung:
**09.03.88 Patentblatt 88/10**

(45) Bekanntmachung des Hinweises auf die
Patenterteilung:
**20.03.91 Patentblatt 91/12**

(84) Benannte Vertragsstaaten:
**DE FR**

(56) Entgegenhaltungen:
**DE-A- 2 115 662
DE-A- 2 459 720
US-A- 3 143 729
US-A- 3 532 928**

(73) Patentinhaber: **ROBERT BOSCH GMBH
Postfach 50
W-7000 Stuttgart 1 (DE)**

(72) Erfinder: **WAGNER, Robert
Silcherstrasse 41
W-7141 Möglingen (DE)**

## Beschreibung

Die Erfindung geht aus von einer Einrichtung zur Kontrolle von elektrischen Verbrauchern in Kraftfahrzeugen nach der Gattung des Hauptanspruches. Eine derartige Einrichtung ist beispielsweise in der US-PS 3 143 729 beschrieben. Diese zeigt eine Signaleinrichtung zur Sichtbarmachung von Defekten an elektrischen Verbrauchern unter Verwendung eines Übertragers, durch den die Leitungen zu den verschiedenen elektrischen Verbrauchern in gegensinniger Richtung hindurchgeführt sind. Verbraucher sind bei dieser bekannten Ausführung elektrische Blinkleuchten, welche von einem Blinkgeber intermittierend angesteuert werden. Im abgeschalteten Betriebszustand der elektrischen Verbraucher ist dabei eine Überwachung nicht möglich.

Aus der US-PS 3 532 928 ist ebenfalls eine Einrichtung zur Kontrolle elektrischer Blinkleuchten nach der Gattung des Hauptanspruches bekannt. Die Überwachung erfolgt hier fortdauernd während der Einschaltphase der elektrischen Leuchten.

Weiterhin ist aus der deutschen Patentanmeldung P 29 34 071.4 eine derartige Einrichtung bekannt, bei der die Zuleitung zu einem elektrischen Verbraucher durch einen elektromagnetischen Übertrager geführt ist, mit dessen Hilfe dann geprüft wird, ob Strom zum elektrischen Verbraucher fließt oder nicht. Der Nachteil dieser bekannten Einrichtung besteht hauptsächlich darin, daß für jeden elektrischen Verbraucher ein Übertrager notwendig ist, was einen hohen Material- und damit auch Kostenaufwand mit sich bringt.

## Vorteile der Erfindung

Die erfindungsgemäße Einrichtung zur Kontrolle von elektrischen Verbrauchern in Kraftfahrzeugen mit den Merkmalen des Hauptanspruches hat gegenüber dem beschriebenen Stand der Technik den Vorteil, daß auch bei abgeschalteten elektrischen Verbrauchern deren Kontrolle auf Funktionstüchtigkeit möglich ist. Hierbei werden unter Verwendung nur eines Übertragers die Zuleitungen zu den einzelnen elektrischen Verbrauchern so durch den elektromagnetischen Übertrager hindurchgeschaltet werden, daß im ungestörten Zustand die sich aufgrund der zu dem elektrischen Verbraucher fließenden Ströme ausbildenden elektromagnetischen Felder gerade gegeneinander aufheben, während im gestörten Zustand, also bei Ausfall eines elektrischen Verbrauchers, dies nicht der Fall ist. Hierbei ist es zweckmäßig, im abgeschalteten Betrieb der elektrischen Verbraucher diese kurzzeitig mit einem Strom zu beaufschlagen, der einerseits groß genug ist, um eine Kontrolle der elektrischen Verbraucher durchzuführen, jedoch andererseits die Funktion dieser elektrischen Verbraucher nicht wesentlich beeinflußt. Diese Kontrolle bei abgeschaltetem elektrischen Verbrauchern ist in besonders vorteilhafter Art und Weise mit Hilfe eines Taktgenerators möglich, dessen Ausschaltdauer groß ist gegenüber seiner Einschaltdauer.

Weitere vorteilhafte Weiterbildungen und Verbesserungen der im Hauptanspruch angegebenen erfindungsgemäßen Einrichtung sind durch die in den Unteransprüchen aufgeführten Maßnahmen möglich.

Zeichnung

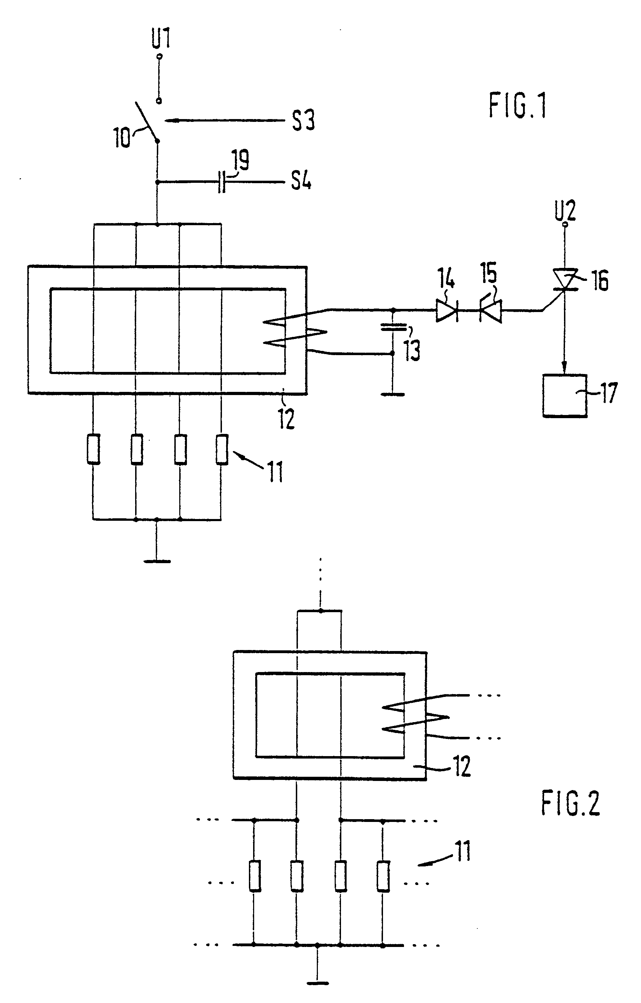

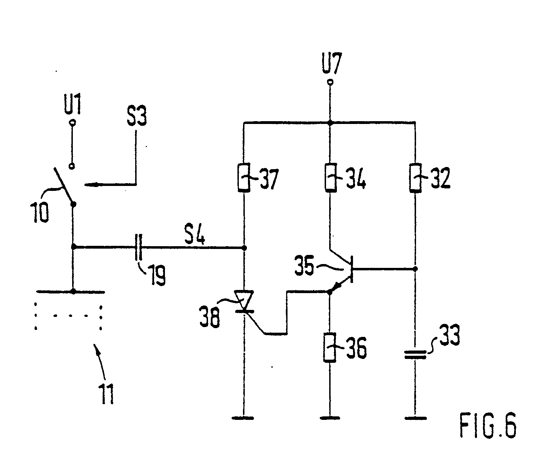

Ausführungsbeispiele der Erfindung sind in der Zeichnung dargestellt und in der nachfolgenden Beschreibung näher erläutert. Die Figuren 1 bis 5 zeigen verschiedene Realisierungsmöglichkeiten der erfindungsgemäßen Glühkerzenüberwachung, während die Figur 6 einen Taktgenerator darstellt.

Beschreibung der Ausführungsbeispiele

Die erfindungsgemäße Einrichtung zur Kontrolle von elektrischen Verbrauchern in Kraftfahrzeugen kann im Grunde genommen im Zusammenhang mit sämtlichen Verbrauchern, die in einem Kraftfahrzeug eingesetzt sind, verwendet werden. Besonders vorteilhaft ist jedoch der Einsatz der genannten Einrichtung zur Kontrolle von Glühkerzen, die insbesondere bei Diesel-Brennkraftmaschinen vorhanden sind.

Figur 1 zeigt eine erste Realisierungsmöglichkeit einer erfindungsgemäßen Glühkerzenüberwachung. Mit der Bezugsziffer 10 ist dabei eine Schalteinrichtung gekennzeichnet, bei der es sich z.B. um ein Relais, einen Transistor, oder ähnliches handelt. Die in diesem Fall vier Glühkerzen tragen das Bezugszeichen 11, während ein elektromagnetischer Übertrager mit 12 gekennzeichnet ist. Die Schalteinrichtung 10 und die einander parallel geschalteten Glühkerzen 11 bilden eine Serienschaltung von der Spannung U1 nach Masse. Die einzelnen Zuleitungen zu den Glühkerzen 11 sind durch den Übertrager 12 hindurchgeführt, und zwar derart, daß die Zuleitungen zu den einzelnen Glühkerzen 11 von jeweils verschiedenen Seiten durch den Übertrager 12 hindurchführen. Zu einer Kapazität 13, die an ihrem einen Anschlußpunkt auf Masse liegt, ist eine elektrische Leitung parallel geschaltet, die beispielhaft zweimal um einen Schenkel des elektromagnetischen Übertragers 12 herumgewickelt ist. Der zweite Anschlußpunkt der Kapazität 13 ist über eine Diode 14 und eine Zenerdiode 15 zum Steuereingang eines Thyristors 16 geführt. Dieser Thyristor 16 ist dabei zum einem an eine Spannung U2 angeschlossen, zum anderen steuert er eine Anzeigeeinrichtung 17 an, die z.B. im einfachsten Fall aus einer Anzeigelampe bestehen kann. In der Schaltung gemäß der Figur 1 wird die Schalteinrichtung 10 von einem Signal S3 angesteuert, während ein Ansteuersignal S4 über eine Kapazität 19 direkt auf den Verbindungspunkt der Schalteinrichtung 10 und der. Parallelschaltung der Glühkerzen 11 einwirkt.

Fließt nun ein Strom über sämtliche vier Glühkerzen 11, so bewirkt dies aufgrund der gegensinnigen Durchführungen, der Zuleitungen zu den Glühkerzen 11 durch den elektromagnetischen Übertrager 12 keine induzierte Spannung an der Kapazität 13, und damit auch keine Ansteuerung der Anzeigeinrichtung 17 durch den Thyristor 16. Ist jedoch eine der vier Glühkerzen 11 defekt, fließt also kein Strom über diese defekte Glühkerze, so hat dies zur Folge, daß an der Kapazität 13 eine Spannung ansteht, die über die Diode 14 und die Zenerdiode 15 den Thyristor 16 zündet, und damit eine Anzeige der defekten Glühkerze mit Hilfe der Anzeigeeinrichtung 17 hervorruft. Die Diode 14 hat dabei die Aufgabe, die Spannung an der Kapazität gleichzurichten, während mit Hilfe der Zenerdiode 15 eine Schwelle gebildet wird, die von der gleichgerichteten Spannung zur Zündung des Thyristor 16 überschritten werden muß. Mit Hilfe der Zenerdiode 15 wird also das unzulässige und/oder falsche Anzeigen von defekten Glühkerzen aufgrund z.B. von Spannungsschwankungen oder ähnlichem sicher vermieden. Durch den Kondensator 13 erspart man die Zweiweggleichrichtung der induzierten Spannung.

Die Figur 2 zeigt eine weitere Realisierungsmöglichkeit der erfindungsgemäßen Glühkerzenüberwachung gemäß der Figur 1. Im Grunde genommen entspricht die Einrichtung der Figur 2 weitgehend der Einrichtung der Figur 1, mit der Ausnahme, daß durch den elektromagnetischen Übertrager 12 nur zwei Drähte gegensinnig hindurchgeführt sind. Die Glühkerzen werden also gemäß der Figur 2 erst nach dem Übertrager 12 in zwei Grunppen parallelgeschaltet. Ist nun eine der dargestellten Glühkerzen 11 defekt, fließt also kein Strom mehr durch diese Glühkerze, so verändert sich der Gesamtstrom durch die betreffende, durch den Übertrager 12 hindurchgeführte Zuleitung. Dies bedeutet, daß die Ströme durch die beiden zu den Glühkerzen führenden Drähte nicht mehr gleich groß sind, und damit an der in der Figur 1 dargestellten Kapazität 13 wieder eine Spannung sich ergibt, die zu einer Anzeige der defekten Glühkerze mit Hilfe der Anzeigevorrichtung 17 führt.

Allgemein ist es also mit Hilfe der Einrichtungen der Figuren 1 und 2 möglich, bei einer geraden Anzahl von Glühkerzen einen Defekt einer Glühkerze zu erkennen. Zu diesem Zweck können entweder alle Drähte durch den jeweiligen Übertrager hindurchgeführt werden, wobei die Hälfte der Drähte im Vergleich zur anderen Hälfte der Drähte gegensinnig durch den Übertrager hindurchgeführt sind, oder es werden nur zwei Drähte, jedoch wieder in gegensinniger Richtung durch den Übertrager geführt, wobei die Glühkerzen dann erst nach dem Übertrager jeweils zur Hälfte in Parallelschaltung an einen der beiden Drähte angeschlossen sind. Wichtig ist bei beiden Ausführungsmöglichkeiten, daß eine gerade Anzahl von Zuleitungen durch den Übertrager hindurchgeht.

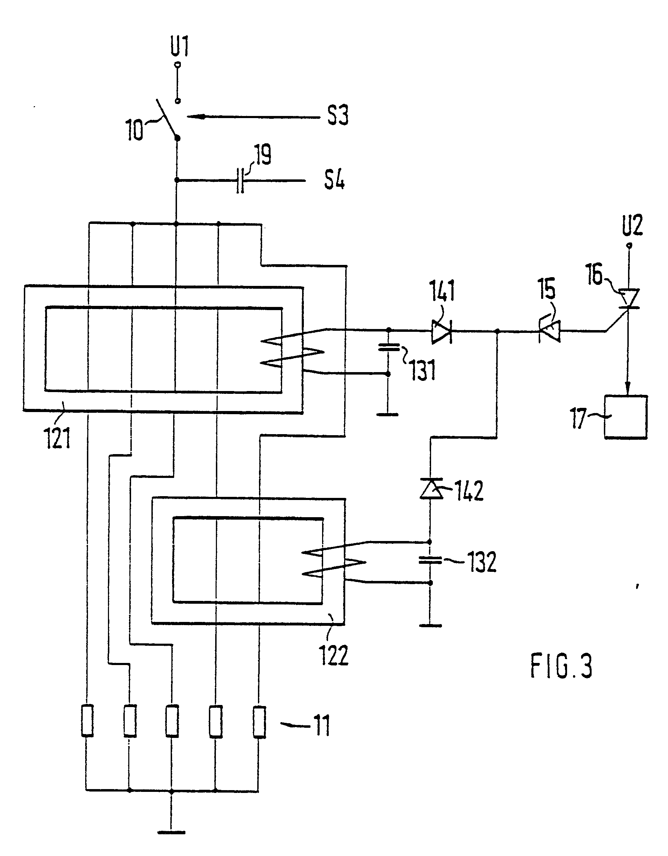

Figur 3 zeigt eine dritte Realisierungsmöglichkeit einer erfindungsgemäßen Glühkerzenüberwachung. Diese ist für eine ungerade Anzahl von Glühkerzen, beispielhaft für fünf Glühkerzen ausgelegt. Zum Zweck der Überwachung sind in der Figur 3 die Zuleitungen zu den fünf Glühkzerzen durch insgesamt zwei Übertrager hindurchgeführt, nämlich durch die Übertrager 121 und 122. Die Zuleitungen sind dabei so durch diese Übertrager hindurchgeführt, daß durch jeden Übertrager eine gerade Anzahl von Zuleitungen hindurchgeleitet ist, wobei jeweils der Hälfte dieser geraden Anzahl in gegensinniger Richtung zur anderen Hälfte durch den Übertrager hindurch läuft. Damit im Beispiel der Figur 3 diese Forderungen alle erfüllt werden können, ist eine der Zuleitungen durch beide Übertrager 121 und 122 hindurchgeführt. Da im Ausführungsbeispiel der Figur 3 zwei Übertrager vorhanden sind, müssen in diesem Fall auch zwei Kapaziäten 131 und 132 mit den jeweils parallel geschalteten, jeweils um einen Schenkel herumgeführten Zuleitungen vorhanden sein, sowie des Weiteren auch noch zwei Dioden 141 und 142. Die Ausgänge der beiden zuletzt genannten Dioden sind dann mit der Zenerdiode 15 verbunden. Der restliche Aufbau der Schaltung der Figur 3 Wie auch ihre Funktionsweise entspricht dann dem in Figur 1 dargestellten Ausführungsbeispiel.

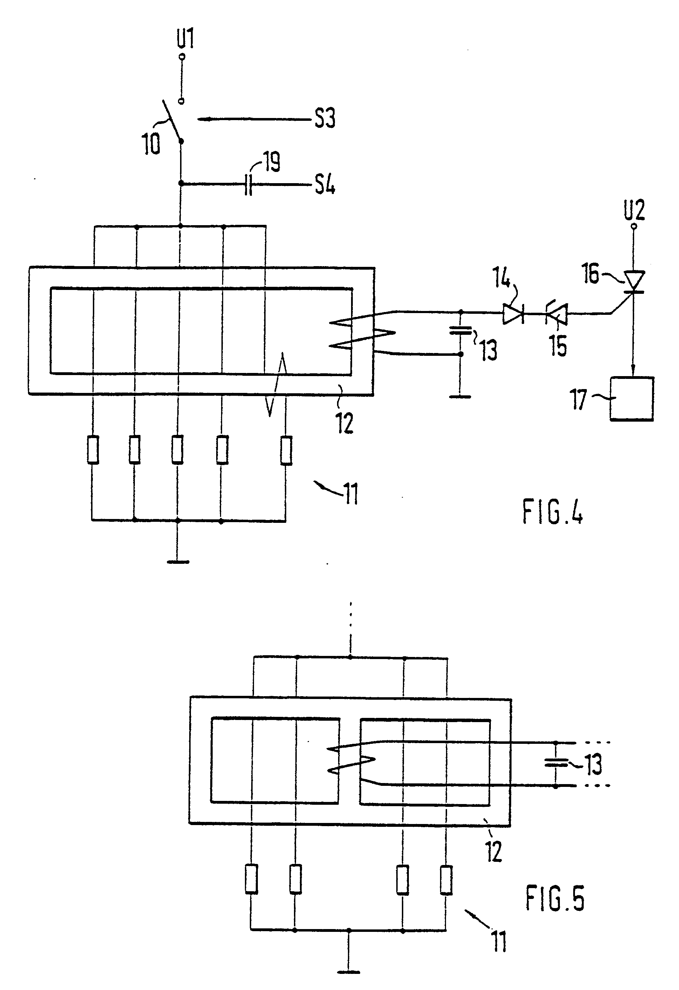

Die Figur 4 zeigt eine Weitere Realisierungsmöglichkeit einer erfindungsgemäßen Glühkerzenüberwachung, bei der ebenfalls für eine ungerade Anzahl von Glühkerzen eine Überwachung stattfindet. Bei der dargestellten Schaltung ist jedoch im vergleich zur Figur 3 nur ein Übertrager notwendig. Damit jedoch auch im Ausführungsbeispiel der Figur 4 die Forderung nach der jeweils gleichen Anzahl in gleicher Richtung durch den Übertrager 12 hindurchgeführten Zuleitungen erfüllt ist, muß in diesem Fall eine der Zuleitungen zweimal durch den Übertrager 12 hindurchgeführt Werden. Prinzipiell ist es dabei auch möglich, die drei linken Zuleitungen der Figur 4 zusammengefaßt als eine Leitung durch den Übertrager 12 hindurchzuführen. Damit dann jedoch wieder die Forderung nach der gleichen Anzahl in gleicher Richtung durch den Übertrager 12 hindurchgeführten Zuleitungen erfüllt ist, muß die verbleibende mittlere Zuleitung genau in der anderen Richtung durch den Übertrager 12 geführt Werden. Der restliche Aufbau der Schaltung der Figur 4 und auch die Funktionsweise dieser Schaltung entspricht dann prinzipiell der Schaltung nach Figur 1 bzw. Figur 3.

Die Figuren 3 und 4 zeigen Überwachungseinrichtungen für fünf Glühkerzen. Es ist auch möglich, ausgehend von dem dort dargestellten Grundprinzip, entsprechende Schaltungen für beliebige ungerade Anzahlen von Glühkerzen zu realisieren. Wichtig ist immer nur die grundsätzliche Voraussetzung, daß durch einen Übertrager gleichviele Zuleitungen in derselben Richtung durchgeführt sind.

Figur 5 zeigt eine weitere Realisierungsmöglichkeit einer erfindungsgemäßen Glühkerzenüberwachung. Bei dieser Moglichkeit besitzt der Übertrager 12 im Vergleich zu den Übertragern der Figuren 1 bis 4 einen Mittelsteg. Die parallel zur Kapazität 13 liegende Leitung ist dann in der Figur 5 nicht um einen Seitensteg gewickelt, sondern um den genannten Mittelsteg. Aus diesem Grund müssen bei einer Realisierung gemäß der Figur 5 die Zuleitungen auch entsprechend, im gezeigten Beispiel alle in derselben Richtung, durch den Übertrager 12 hindurchgeführt werden. Es ist auch möglich, den Übertrager 12 gemäß der Figur 5 zusammen mit anderen Anzahlen von Glühkerzen 11 einzusetzen. Die Zuleitungen zu den Glühkerzen müssen dann jeweils entsprechend dem Anwendungsfall durch den Übertrager hindurchgeführt werden.

Wie im Zusammenhang mit den Figuren 1 bis 5 ausgeführt wurde, ist eine Überwachung der Funktionstüchtigkeit der Glühkerzen 11 genau dann möglich, wenn ein Strom durch dei Glühkerzen fließt. Ist nun aufgrund des Ansteuer-signals S3 die Schaltungeinrichtung 10 geöffnet, so fließt in diesem Moment kein Strom mehr zu den Glühkerzen 11, womit auch eine Überwachung derselben nicht mehr möglich ist. Es ist jedoch in diesem Betriebszustand möglich, mit Hilfe eines Signals S4 über die Kapazität 19 beliebige kurzzeitige Spannungspulse zu den Glühkerzen 11 zu führen. Diese Pulse müssen dabei einerseits so groß sein, daß eine defekte Glühkerse mittels des Übertragers 12 von der nachfolgenden Schaltung erkannt werden kann, andererseits müssen diese Pulse jedoch so klein sein, daß sie die Temperatur der Glühkerzen 11 nur unwesentlich beeinflussen. Eine weitere Möglichkeit zur kurzzeitigen Versorgung der Glühkerzen 11 mit Strom ist ein kurzzeitiges Schießen der Schalteinrichtung 10 in deren normalerweise geöffneten Betriebszustand. Das eigentliche Signal S3 muß zu diesem Zweck von einem Ansteuerimpuls überlagert werden, der prinzipiell dem Signal S4 entsprechen kann.

Wichtig ist beim erfindungsgemäßen Gegenstand, daß die Zuleitungen zu den Glühkerzen so durch einem Übertrager hindurchgeführt sind, daß bei funktionsflähigen Glühkerzen kein Ausgangssignal an der Auswerteeinrichtung entsteht, daß jedoch durch den Defekt einer Glühkerse ein solches Ausgangssignal erzeugt, und damit der Defekt angezeigt wird. In den Ausführungsbeispielen sind mehrere, voneinander verschiedene Möglichkeiten von Überwachungsschaltungen dargestellt, es liegt jedoch im Bereich des Wissens eines Fachmanns, die entsprenchenden Möglichkeiten für den jeweiligen Anwendungsfall zu kombinieren.

Eine weitere Einrichtung zur Erzeugung von Impulsen, mit deren Hilfe die Glühkerzen 11 kurzzeitig mit Spannung versorgt werden können, zeigt die Figur 6. Die an der Spannung U1 liegende Serienschaltung der Schalteinrichtung 10 und der Glühkerzen 11 ist aus den Figuren 1 bis 5 schon bekannt. Gemäß der Figur 6 werden mit Hilfe der schon bekannten Kapazität 19 die Glühkerzen 11 mit Impulsen versorgt. Zu diesem Zweck ist eine Schaltung aufgebaut, die aus Widerständen 32, 34, 36 und 37, einer Käpazität 33, einem Transistor 35, sowie einem Thyristor 38 besteht. Besonders vorteilhaft ist es, für den Transistor 35 einen Unijunction-Transistor zu verwenden. Dabei bilden der widerstand 32 und die Kapazität 33, der widerstand 34 und der Transistor 35 und der widerstand 36, sowie der widerstand 37 und der Thyristor 38 jeweils eine Serienschaltung. Insgesamt sind dann die drei genannten Serienschaltungen einander parallel geschaltet, Wobei die Basis des Transistors 35 mit dem Verbindungspunkt des Widerstands 32 und der Kapazität 33 verbunden ist, während der Verbindungspunkt des Transistors 35 und des widerstands 36 an den Thyristor 38 angeschlossen ist. Die gesamte Parallelschaltung liegt dabei zwischen einer Spannung U7 und Masse. Schließlich Wird das die Kapazität 19 ansteuernde Signal S4 vom Verbindungspunlt des Widerstands 37 und des Thyristors 38 abgenommen.

Sind die Kapazitäten 19 und 33 anfangs ungeladen, so werden sie über die Widerstände 37 und 32 aufgeladen. Erreicht dann das Basispotential des Transistors 35 eine Größe, die ausreicht, damit der Transistor 35 leitend wird, so wird in diesem Augenblick auch der Thyristor 38 gezündet, was dann einen Impuls über die Kapazität 19 auf die Glühkerzen 11 zur Folge hat. Infolge dieses Impulses bzw. des leitenden Transistors 35 werden die beiden Kapazitäten 19 und 33 wieder entladen, der Transistor 35 geht wieder in seinem sperrenden Zustand über und der gesamte Vorgang beginnt von vorne.

Mit Hilfe der in der Figur 6 dargestellten Schaltung ist es also möglich, kurzzeitige Impulse über die Kapazität 19 an die Glühkerzen 11 weiterzugeben. Das Verhältnis von Einschaltdauer zu Ausschaltdauer dieser Impulse ist dabei abhängig von der Dimensionierung der beschriebenen Schaltung, insbesondere von der Größe des Widerstands 32 und der Kapazität 33.

Dabei ist im Fall der Figur 6 der dargestellte Taktgenerator unabhängig von dem aufgrund des Ansteuersignals S3 normalerweise bestehenden Betriebszustands der Schalteinrichtung 10. Für einen Fachmann ist es nun aber möglich, auch andere Taktgeneratoren zu verwenden, so z.B. einfache, mit Operationsverstärkern aufgebaute Kippschaltungen der Multivibratoren oder ähnliches. Auch liegt es im Bereich des Fachwissens eines entsprechenden Fachmanns, nicht über die Kapazität 29 kurzzeitige Impulse an die Glühkerzen 11 zu liefern, sondern mit Hilfe des Taktgenerators den Schalter 10 anzusteuern und damit die Glühkerzen 11 kurzzeitig mit der Spannung U1 zu verbinden. Dieser letzten Möglichkeit entspricht daher die Überlägerung des Impulssignals des Taktgenerators mit dem Signal 53.

## Ansprüche

1. Einrichtung zur Kontrolle von elektrischen Verbrauchern in Kraftfahrzeugen mit wenigstens zeitweise stromdurchflossenen elektrischen Verbrauchern, sowie mit wenigstens einem elektromagnetischen Übertrager mit nachfolgender Auswerteschaltung, wobei die Leitungen zu den elektrischen Verbrauchern in zueinander gegensinniger Richtung durch den wenigstens einen elektromagnetischen Übertrager hindurchgeführt sind und der Defekt eines elektrischen Verbrauchers mit Hilfe einer Leitung erkannt wird, die um einen Kern des elektromagnetischen Übertragers herumgewickelt ist, dadurch gekennzeichnet, daß mit Hilfe eines Taktgenerators auch in normalerweise abgeschaltetem Betriebszustand der elektrischen Verbraucher diese kurzzeitig von einem elektrischen Strom durchflossen werden.

2. Einrichtung nach Anspruch 1, dadurch gekennzeichnet, daß die Auszeit des Taktgenerators groß ist gegenüber der Einzeit desselben.

3. Einrichtung nach Anspruch 1 oder 2, dadurch gekennzeichnet, daß der Taktgenerator mit Hilfe wenigstens eines beschalteten Operationsverstärkers gebildet wird.

4. Einrichtung nach Anspruch 1, 2 oder 3, dadurch gekennzeichnet, daß der Taktgenerator direkt den Strom durch die elektrischen Verbraucher liefert oder indirekt den Strom durch die elektrischen Verbraucher schaltet.

5. Einrichtung nach einem der Ansprüche 1 bis 4, dadurch gekennzeichent, daß bei einander parallel geschalteten elektrischen Verbrauchern nur zwei Leitungen zu den elektrischen Verbrauchern durch den wenigstens einen elektromagnetischen Übertrager hindurchgeführt sind, und die Parallelschaltung dann nach dem elektromagnetischen Übertrager erst stattfindet.

6. Einrichtung nach einem der Ansprüche 1 bis 4, dadurch gekennzeichnet, daß bei einer ungeraden Anzahl von elektrischen Verbrauchern die Leitung zu einem der elektrischen Verbraucher zweimal durch den elektromagnetischen Übertrager hindurchgeführt ist.

7. Einrichtung nach einem der Ansprüche 1 bis 5, dadurch gekennzeichnet, daß bei einer ungeraden Anzahl von elektrischen Verbrauchern zwei elektromagnetische Übertrager vorhanden sind, wobei wenigstens eine Leitung der elektrischen Verbraucher durch beide Übertrager hindurchgeführt ist.

8. Einrichtung nach einem der Ansprüche 1 bis 7, dadurch gekennzeichnet, daß der mit den Anzügselementen verbendenen Leitung eine Kapazität parallel geschaltet ist.

9. Einrichtung nach Anspruch 8, dadurch gekennzeichnet, daß mit Hilfe weiterer Elemente eine Spannung auf der Kapazität, und damit der Defekt eines der elektrischen Verbraucher angezeigt wird.

## Claims

1. Device for controlling electrical loads in motor vehicles, comprising electrical loads which are at least temporarily current-carrying, and comprising at least one electromagnetic transformer with a downstream evaluation circuit, the feeders to the electrical loads being led in mutually opposite directions through the at least one electromagnetic transformer and the failure of an electrical load being identified with the aid of a feeder which is wound around a core of the electromagnetic transformer, characterized in that even in the normally switched off operating state of the electrical loads, the latter briefly carry an electrical current with the aid of a clock generator.

2. Device according to Claim 1, characterized in that the off-time of the clock generator is large by comparison with the on-time thereof.

3. Device according to Claim 1 or 2, characterized in that the clock generator is formed with the aid of at least one interconnected operational amplifier.

4. Device according to Claim 1, 2 or 3, characterized in that the clock generator delivers the current directly through the electrical loads, or switches the current indirectly through the electrical loads.

5. Device according to one of Claims 1 to 4, characterized in that in the case of electrical loads connected in parallel to one another only two feeders to the electrical loads are led through the at least one electromagnetic transformer, and the parallel connection does not then take place until downstream of the electromagnetic transformer.

6. Device according to one of Claims 1 to 4, characterized in that in the case of an odd number of electrical loads the feeder to one of the electrical loads is led twice through the electromagnetic transformer.

7. Device according to one of Claims 1 to 5, characterized in that in the case of an odd number of electrical loads two electrical transformers are present, at least one feeder of the electrical loads being led through both transformers.

8. Device according to one of Claims 1 to 7, characterized in that a capacitor is connected in parallel to the feeder connected to the display elements.

9. Device according to Claim 8, characterized in that with the aid of further elements a voltage is on the capacitor, and consequently the failure of one of the electrical loads is displayed.

## Revendications

1. Agencement pour contrôler des consommateurs d'électricité dans des véhicules automobiles avec des consommateurs d'électricité parcourus au moins temporairement par le courant, ainsi qu'avec au moins un transmetteur électromagnétique avec un circuit d'exploitation branché à la suite, agencement dans lequel les liaisons vers les consommateurs d'électricité passent en sens inverse les unes par rapport aux autres à travers un transmetteur électromagnétique prévu à au moins un exemplaire, tandis que le défaut d'un consommateur d'électricité est détecté à l'aide d'une liaison qui est enroulée autour d'un noyau du transmetteur électromagnétique, agencement caractérisé en ce qu'à l'aide d'un générateur d'impulsions le consommateur d'électricité est parcouru pendant un court instant par un courant électrique même lorsque ce consommateur est dans un état de fonctionnement normalement déconnecté.

2. Agencement selon la revendication 1, caractérisé en ce que la durée de mise hors circuit du générateur d'impulsions est importante par rapport à la durée de mise en circuit de ce générateur.

3. Agencement selon la revendication 1 ou la revendication 2, caractérisé en ce que le générateur d'impulsions est réalisé à l'aide d'au moins un amplificateur opérationnel.

4. Agencement selon la revendication 1, la revendication 2 ou la revendication 3, caractérisé en ce que le générateur d'impulsions délivre directement le courant à travers le consommateur d'électricité ou bien commute indirectement le courant à travers le consommateur d'électricité.

5. Agencement selon l'une des revendications 1 à 4, caractérisé en ce que dans le cas de consommateurs d'électricité branchés en parallèle, seules deux liaisons vers ces consommateurs d'électricité passent à travers le transmetteur électromagnétique prévu à au moins un exemplaire, tandis que le branchement en parallèle n'a lieu qu'après ce transmetteur électromagnétique.

6. Agencement selon l'une des revendications 1 à 4, caractérisé en ce que dans le cas d'un nombre impair de consommateurs d'électricité la liaison vers un de ces consommateurs d'électricité passe deux fois à travers le transmetteur électromagnétique.

7. Agencement selon l'une des revendications 1 à 5, caractérisé en ce que dans le cas d'un nombre impair de consommateurs d'électricité il est prévu deux transmetteurs électromagnétiques, tandis qu'au moins une liaison des consommateurs d'électricité passe à travers les deux transmetteurs.

8. Agencement selon l'une des revendications 1 à 7, caractérisé en ce qu'une capacité est branchée en parallèle sur la liaison reliée aux éléments d'affichage.

9. Agencement selon la revendication 8, caractérisé en ce qu'à l'aide d'autres éléments une tension est appliquée à la capacité et qu'ainsi le défaut de l'un des consommateurs d'électricité est indiqué.

FIG.1

FIG.2

U1

S3

10

19

S4

U2

141    15    16

131    17

121

142

132

122    FIG.3

11

FIG.4

FIG.5

FIG.6